# DEMANDE DE BREVET EUROPEEN

(11) **EP 1 241 784 A1**
(43) Date de publication de la demande: **18.09.2002**
(21) Numéro de dépôt: 02075834.8
(22) Date de dépôt: 04.03.2002
(51) Int. Cl.: H03H 17/00, H04L 7/02

(54) **Modulateur numerique**

(30) Priorité: 13.03.2001 FR 0103413
(71) Demandeur: Koninklijke Philips Electronics N.V., 5621 BA Eindhoven (NL)
(72) Inventeur: Bedgedjian, Jean-Christophe, 75008 Paris (FR)
(74) Mandataire: Lottin, Claudine

(57) **Abrégé**

La présente invention concerne un modulateur numérique (DM) et un procédé de modulation associé. Le modulateur numérique (DM) comporte une fréquence d'horloge (Fclk) et est apte à traiter un signal numérique (S(TA)) comprenant des symboles (SYMB) échantillonnés à une fréquence symbole (Fsy) Il se caractérise par des moyens d'interpolation (INT) aptes à interpoler un nouvel échantillon (OUT) à partir de paramètres d'interpolation (δ, SIGN) et de signaux (LS, TS, F0, F2) dérivés du signal numérique (S(TA)), des paramètres d'interpolation (δ, SIGN) étant calculés en fonction d'un ratio (R) variable et réel proportionnel à la fréquence symbole (Fsy) sur la fréquence d'horloge (Fclk).

## Description

La présente invention concerne un modulateur numérique comportant une fréquence d'horloge et étant apte à traiter un signal numérique comprenant des symboles échantillonnés à une fréquence symbole. Elle concerne également un procédé de traitement du signal adapté audit modulateur.
Elle trouve une application particulière notamment lors de transmissions de signaux numériques via des supports filaires tels que le câble, aériens tels que les faisceaux hertziens ou encore optiques tels que les fibres optiques.

Le brevet FR2753590 déposé le 19 septembre 1996, correspondant au brevet US6134225 déposé le 17 septembre 1997, décrit un système de transmissions numériques par satellites. Le système comporte un modulateur numérique. Le modulateur comporte un oscillateur qui génère une fréquence d'horloge fixe. Dans le cadre de transmissions d'un signal numérique, ledit signal est traité sous forme de symboles à transmettre. Une fréquence symbole est associée à la transmission de ces symboles. Dans le cadre de transmissions via un câble, par exemple, cette fréquence symbole comporte des valeurs fixées dans des normes telles que DAVIC (Digital Audio-Visual Council),-DVB (Digital Video Broadcasting) éditée par l'ETSI (European Telecommunications Standard Institute) référencée ETS300800 ou encore DOCSIS (Data Over Cable Service Interface Specifications) éditée par le RFI (Radio Frequency Interface) référencée SP-RFI-104-98724. Lesdites valeurs sont respectivement 256 kbits/s ou des multiples de 1.544 Mbits/s ou encore 160 ksymb/s. Suivant les fréquences symboles susceptibles d'être utilisées, la fréquence d'horloge du modulateur est associée de façon appropriée. Ainsi, suivant la norme implémentée, on choisit la fréquence d'horloge de telle manière à ce qu'elle corresponde au plus petit commun multiple des fréquences symboles pouvant être utilisées. Dans les systèmes actuels, Le ratio entre la fréquence d'horloge et la fréquence symbole doit être un entier et parfois même une puissance de 2.
Bien que cet état de la technique permette de gérer plusieurs fréquences symboles, cette gestion est d'autant plus complexe qu'il y a de fréquences symboles utilisées. De plus, ce système est peu flexible puisqu'il ne permet pas une utilisation continue de la gamme des fréquences symboles.

Aussi un problème technique à résoudre par l'objet de la présente invention est de proposer un modulateur numérique comportant une fréquence d'horloge et étant apte à traiter un signal numérique comprenant des symboles échantillonnés à une fréquence symbole, ainsi qu'un procédé de traitement de signal numérique associé, qui permettraient de simplifier la gestion des fréquences symboles et d'étendre la gamme des fréquences symboles utilisables par ledit modulateur.

Une solution au problème technique posé se caractérise, selon un premier objet de la présente invention, en ce que le modulateur numérique comporte
- des moyens d'interpolation aptes à interpoler un nouvel échantillon à partir de paramètres d'interpolation et de signaux dérivés du signal numérique, des paramètres d'interpolation étant calculés en fonction d'un ratio variable et réel proportionnel à la fréquence symbole sur la fréquence d'horloge.

Selon un second objet de la présente invention, cette solution se caractérise, en ce que le procédé de traitement de signal numérique comporte les étapes de :
- calculer des paramètres d'interpolation,
- calculer un nouvel échantillon à partir des paramètres d'interpolation et de signaux dérivés du signal numérique, des paramètres d'interpolation étant calculés en fonction d'un ratio variable et réel proportionnel à la fréquence symbole sur la fréquence d'horloge.

Ainsi, comme on le verra en détail plus loin, les moyens d'interpolation permettent de traiter le signal numérique de telle manière que la fréquence d'horloge ne dépende plus de la ou des fréquences symboles que l'on désire utiliser. Le choix du ratio est libre de toute contrainte. De ce fait la gestion des fréquences symboles est plus flexible et simplifiée.

La description qui suit, en regard des dessins annexés, le tout donné à titre d'exemple non limitatif, fera bien comprendre en quoi consiste l'invention.
- la Fig. 1 illustre de façon schématique une architecture de modulateur numérique selon l'invention,
- la Fig. 2 est un schéma de symboles gérés par le modulateur de la figure 1,
- la Fig. 3 un schéma de moyens d'interpolation compris dans le modulateur de la figure 1,
- la Fig. 4 illustre de façon schématique une première partie des moyens d'interpolation de la figure 3,
- la Fig. 5 représente des courbes relatives à des paramètres des moyens d'interpolation de la figure 3,
- la Fig. 6 représente un organigramme de calcul effectué par les moyens d'interpolation de la figure 3,
- la Fig. 7 illustre de façon schématique une deuxième partie des moyens d'interpolation de la figure 3.

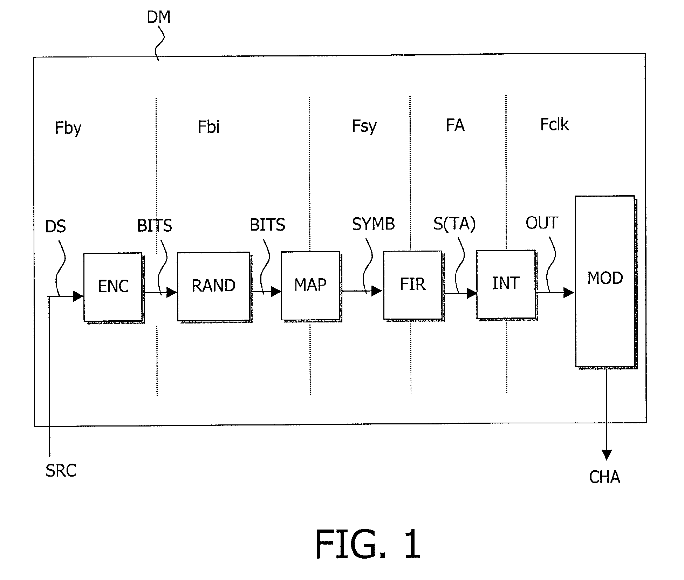

Le présent exposé de l'invention a trait à un exemple de modulateur numérique DM utilisé dans le domaine de l'interactivité par câble. Dans ce domaine, des signaux numériques sont échangés via un canal physique de transmissions hybrides tel qu'un câble coaxial et de la fibre optique. Le modulateur numérique DM permet la transmission de ces signaux via un tel canal. Sur la figure 1 est représenté un schéma d'une architecture dudit modulateur DM. Ledit modulateur comporte une fréquence d'horloge Fclk, des moyens de détection d'erreurs ENC, des moyens d'embrouillage RAND, des moyens d'étiquetage MAP, des premiers moyens de filtrage FIR, des moyens d'interpolation INT et des moyens de modulation MOD sur une fréquence porteuse Fca.

Le modulateur numérique DM reçoit en entrée un signal numérique DS à partir d'une ou plusieurs sources telles que des mémoires d'un modem câble. Ledit signal DS est composé d'octets et est transmis selon une première fréquence Fby en octets/s. Afin de transmettre ledit signal numérique DS sur un canal, le modulateur émet un signal sinusoïdal. A cet effet, le signal numérique DS est modulé sur une fréquence porteuse Fca. La fréquence porteuse est déterminée par la norme utilisée. Ainsi pour la norme DVB, la fréquence porteuse peut prendre une valeur entre 5 MHz et 65 MHz, tandis que pour la norme DOCSIS, elle prend une valeur entre 5 MHz et 42 MHz. Cependant, avant d'effectuer une modulation, plusieurs étapes préalables sont nécessaires. On prend comme exemple une modulation QPSK en quadrature de phase (appelée dans la langue anglaise « Quadrature Phase Shift Keying »). Les étapes sont décrites ci-après.

Lors d'une transmission d'un signal DS via un canal CHA, ce dernier peut apporter des perturbations qui engendrent des erreurs lors de la réception de DS. Aussi, les moyens de détection d'erreurs ENC permettent de transformer ledit signal DS de telle sorte que les erreurs seront détectées et corrigées par la suite. Ces moyens ENC sont basés sur un principe de redondance et de vraisemblance appelé « Reed-Solomon », connu de l'homme du métier. A la sortie desdits moyens de détection ENC, le signal numérique est sérialisé sous forme binaire selon une fréquence binaire Fbi en bits/s (un octet étant égal à 8 bits).

La source SRC émet à priori des séquences de bits quelconques. Il faut éviter la transmission d'une séquence constante ce qui aurait comme effet d'émettre sur le canal CHA une fréquence pure de forte puissance, ce qui risquerait d'endommager le canal. . Afin d'éviter un tel risque, les moyens d'embrouillage RAND embrouillent le signal numérique avec une séquence pseudo-aléatoire afin de le rendre pseudo-aléatoire, c'est-à-dire aléatoire à court terme

Cependant, le signal numérique binaire n'est pas transmis directement sur le canal CHA. Il est émis sous forme de symboles SYMB.Les moyens d'étiquetage MAP récupèrent en entrée les bits du signal numérique binaire et les codent sous forme de symboles SYMB

Autrement dit, chaque symbole SYMB code deux bits I et Q, ce qui correspond par exemple au codage suivant.

| I | Q | SYMB |
|---|---|---|
| 0 | 0 | -1 -1 |
| 0 | 1 | -1 1 |
| 1 | 1 | 1 1 |
| 1 | 0 | 1 -1 |

La transmission du signal est alors représentée par une fréquence symbole Fsy. Dans cet exemple, la fréquence binaire Fbi est égale à deux fois la fréquence symbole Fsy. Ainsi, on double une quantité potentielle de bits qui seraient transmis dans le cas où le modulateur numérique ne comporterait pas de moyens d'étiquetage.

Le canal de transmission CHA possède une bande passante qui est partagée entre différents utilisateurs. Par conséquent, le signal transmis par chaque utilisateur est à bande limitée. Pour ce faire, on utilise, préférentiellement, des premiers moyens de filtrage FIR adaptés. De plus, on cherche avec ce filtre à minimiser des interférences inter symboles (ISI) qui engendrent une déformation du signal transmis. A cet effet, les premiers moyens de filtrage FIR utilisés sont, par exemple, un filtre en racine de Nyquist à cosinus surélevé de facteur de retombée α bien connu de l'homme du métier. Dans ce cas, à la sortie du filtre, on a un signal numérique S(TA) échantillonné à une première fréquence des échantillons FA = 2Fsy.

Par la suite, les moyens d'interpolation INT permettent de suréchantillonner le signal numérique S(TA) à une deuxième fréquence des échantillons Fclk > 2Fmax, Fmax étant la fréquence maximum du signal transmis sur la fréquence porteuse Fca, afin de respecter le critère énoncé par le théorème de Shannon, et Fclk étant la fréquence d'horloge du modulateur numérique DM. On notera que Fmax = Fca + Fsy(1+α). α est le facteur de retombée et est appelé « roll-off » dans la langue anglaise et est égal à 30% dans la norme DVB et 25% dans la norme MCNS.

D'après un mode de réalisation non limitatif, les moyens d'interpolation INT sont décrits dans le brevet US05349548 délivré au nom de la société PHILIPS ELECTRONICS N.V. et déposé le13 mai 1993. L'ensemble du contenu de ce brevet doit être considéré comme faisant partie intégrante de la présente demande. Ces moyens d'interpolation INT permettent de faire une interpolation à partir d'un signal numérique échantillonné d'entrée S(TA) en retardant artificiellement, d'un retard ΔT, ledit signal pour calculer de nouveaux échantillons OUT. On estime que le retard ΔT requis maximum est de plus ou moins TA/2, TA étant la période des échantillons en entrée. On couvre ainsi l'ensemble des échantillons nouveaux OUT que l'on peut calculer à partir des échantillons d'entrée S(TA). Par exemple, si on a trois échantillons d'entrée S(1), S(2) et S(3), on calculera les nouveaux échantillons entre [S(0.5), S(1,5)], [S(1,5), S(2,5)] et [S(2,5), S(3.5)]. Afin de calculer de nouveaux échantillons OUT, un terme de correction doit être ajouté aux échantillons d'entrée S(TA). Le terme de correction est une fonction$\text{G(δ) = |δ|*(|δ|*F1+(1-|δ|)*SIGN*F2)}$ Comme nous le verrons en détail plus loin, ladite fonction G(δ)correspond à une fonction de transfert
H(Z) = Z ^{-∂/2} exprimant ledit retard ΔT. On a ΔT = ∂*TA/2 avec ∂ = -1,...,1.. ∂ exprime un délai normalisé par rapport à TA/2.

Nous allons voir ci-après comment cette fonction est calculée et à quoi correspondent les termes qui la composent.

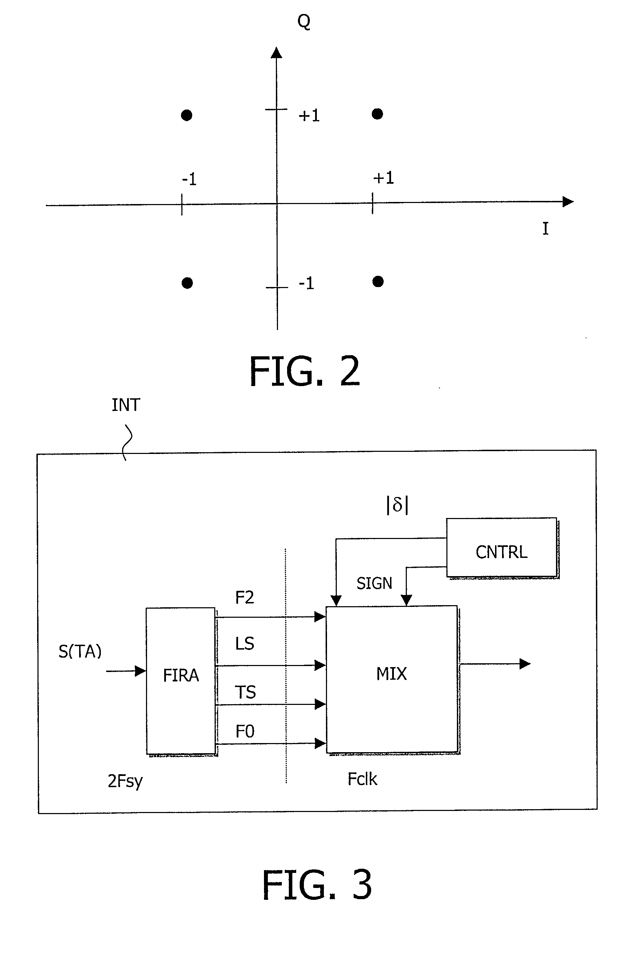

Comme le montre la figure 3, les moyens d'interpolation INT comportent préférentiellement :
- des deuxièmes moyens de filtrage FIRA;
- des moyens de contrôle CNTRL,
- des moyens de calcul d'échantillons MIXER.

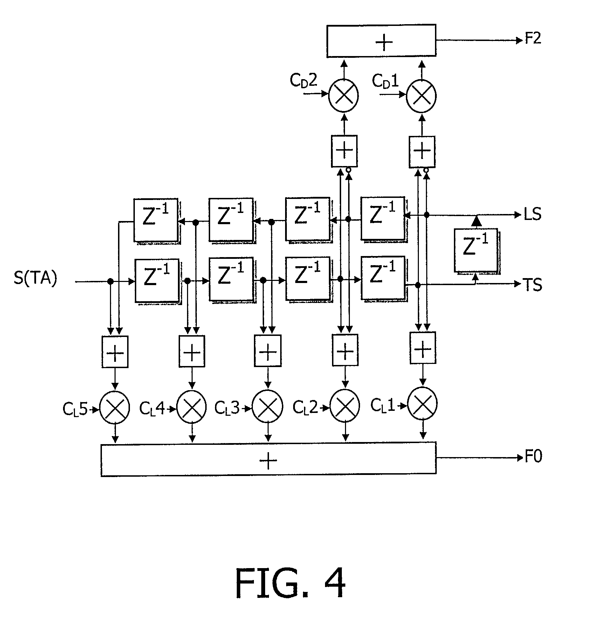

Les deuxièmes moyens de filtrage FIRA permettent de filtrer le signal numérique d'entrée S(TA) afin d'obtenir des signaux dérivés comprenant des signaux de base et des signaux filtrés. Ainsi, à partir d'échantillons du signal numérique d'entrée S(TA), on obtient deux échantillons de base non filtrés LS et TS, un premier signal de référence filtré F0, et un second signal filtré F2. Selon un mode de réalisation non limitatif, la structure des deuxièmes moyens de filtrage FIRA est présentée à la figure 4. Lesdits moyens comportent une ligne à retard et des coefficients multiplicateurs C_{L}, C_{D}. La ligne à retard est constituée de retards Z⁻¹ chacun retardant les échantillons d'entrée S(TA) d'une période d'échantillons TA. On obtient ainsi les signaux de base LS, TS. Les signaux filtrés F0 et F2 sont obtenus en effectuant une étape supplémentaire qui est de multiplier les échantillons d'entrée retardés S(TA) respectivement par cinq coefficients multiplicateurs C_{L}1 à C_{L}5 et deux coefficients multiplicateurs C_{D}1 à C_{D}2. Ces coefficients ont pour valeurs respectives 80/128, -23/128, 10/128, -4/128, 1/128 et -1/32, 2/32. Ensuite, on somme l'ensemble des échantillons ainsi obtenus, comme indiqués sur la figure 4.

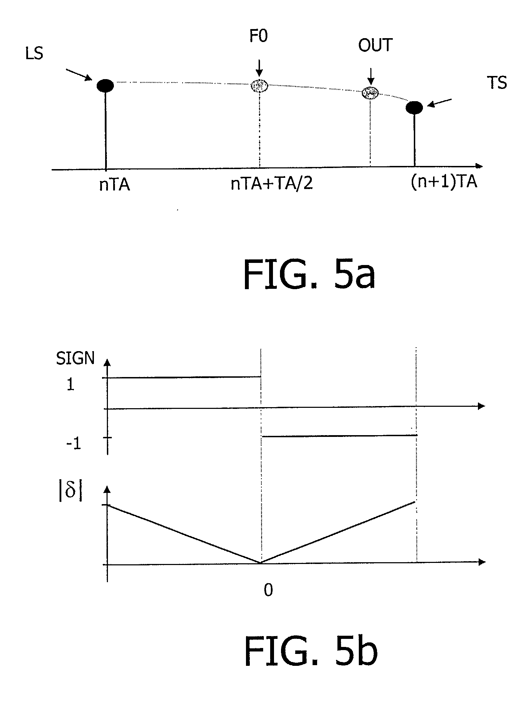

Les moyens de contrôle CNTRL fournissent des paramètres d'interpolation associés à chaque échantillon qui doit être interpolé, c'est-à-dire calculé par interpolation. Ils fournissent ainsi, à chaque front montant d'horloge Fclk, deux paramètres d'interpolation δ et SIGN, et ce, préférentiellement, grâce à un oscillateur numérique de commande NCO (« Numerically Controlled Oscillator » dans la langue anglaise). Les deux paramètres sont représentés à la figure 5b. Le premier paramètre d'interpolation δ correspond à la valeur complémentaire du délai ∂ vu précédemment, et donc δ = -1,...,1. Ledit oscillateur NCO comprend un paramètre de phase µ tel que : =

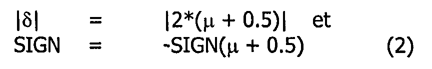

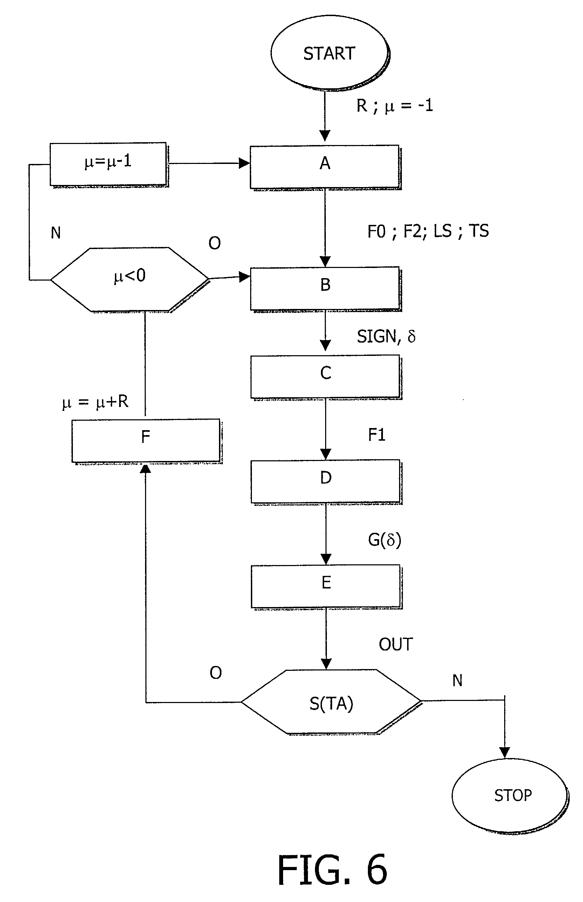

Les moyens de calcul d'échantillons MIXER calculent un nouvel échantillon OUT à partir des paramètres d'interpolation δ et SIGN et de signaux dérivés du signal numérique S(TA). Les signaux dérivés sont les deux signaux de base connus LS et TS et les deux signaux filtrés F0 et F2. L'interpolation d'un échantillon OUT se fait entre les deux signaux de base LS et TS et se déroule de la manière suivante. L'organigramme de la figure 6 schématise les différentes étapes présentées ci-après.

Lors d'une phase d'initialisation START, le paramètre de phase µ est initialisé préférentiellement à -1 afin de se caler sur le premier échantillon de base TS.

Dans une première étape A), on calcule le premier signal filtré de référence F0 et le deuxième signal filtré F2 grâce aux deuxièmes moyens de filtrage FIRA de la figure 4, comme décrit précédemment. Le premier signal filtré de référence F0 est pris comme signal de référence à δ = 0 comme le montre la figure 5a. Sur la figure 5a, n est un entier.. On récupère également les signaux de base LS, TS.

Dans une deuxième étape B), on calcule les paramètres d'interpolation δ et SIGN selon (2).

Dans une troisième étape C), on calcule F1 tel que :$\text{F1 = (échantillon le plus proche - F0)}$ L'échantillon le plus proche est un des échantillons de base qui est le plus proche de l'échantillon à calculer OUT, soit,$\text{quand δ > 0, F1 = LS - F0,}$$\text{quand δ < 0, F1 = TS - F0.}$

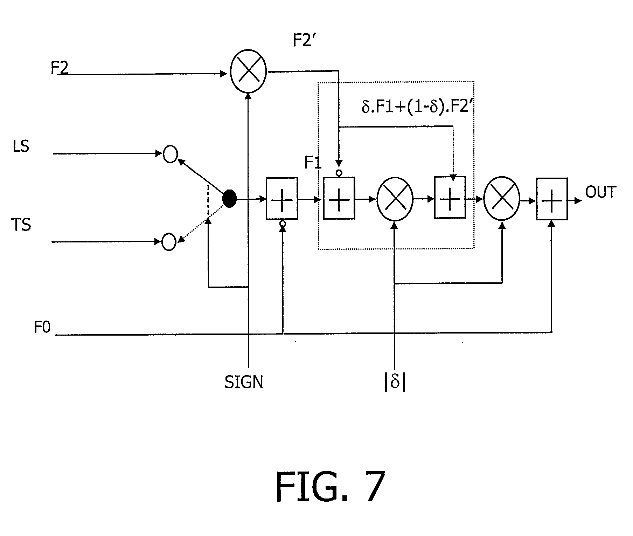

Dans une quatrième étape D), on calcule la fonction G(δ) = |δ|*(|δ|*F1+(1-|δ|)*SIGN*F2) que l'on a vue précédemment. La figure 7 présente un mode de réalisation non limitatif des moyens de calcul d'échantillons MIXER permettant d'obtenir ladite fonction G(δ).

Dans une cinquième étape E), on calcule le nouvel échantillon OUT tel que :$\text{OUT = F0 + G(δ).}$

Dans une sixième étape F), on incrémente le paramètre de phase µ d'un ratio R. Ledit ratio R est égal à la fréquence des échantillons d'entrée FA sur la fréquence d'horloge Fclk, soit :$\text{R = FA/Fclk ou R = 2Fsy/Fclk.}$

Tant que le paramètre de phase µ est négatif, on recommence les étapes précédentes à partir de l'étape B) pour un nouvel échantillon OUT.

Dès que le paramètre de phase µ devient positif, on décrémente ledit paramètre de 1 et on recommence les étapes précédentes à partir de l'étape A) pour un nouvel échantillon OUT. La décrémentation permet de se recaler pour l'interpolation sur les échantillons de base connus TS et LS, car on a décalé les échantillons dans la ligne à retard, d'une période TA.

On s'arrête lorsqu'il n'y a plus d'échantillons S(TA), c'est-à-dire lorsqu'il n'y a plus de signaux à transmettre. Par conséquent, on obtient un signal de sortie y(Tclk) suréchantillonné à la fréquence d'horloge Fclk et on a des paramètres d'interpolation δ, SIGN qui sont calculés en fonction du ratio R variable et réel proportionnel à la fréquence symbole Fsy sur la fréquence d'horloge Fclk, le paramètre de phase µ permettant de calculer lesdits paramètres d'interpolation δ, SIGN en fonction dudit ratio R.

On calcule autant d'échantillons que l'on veut entre les deux échantillons de base TS et LS. Il suffit d'adapter l'interpolation entre les deux échantillons de base LS et TS, notamment en fonction du ratio R voulu. Par exemple, si R = 10, on calcule 10 échantillons OUT (1.0) OUT(1,1), OUT(1,2), OUT(1,3), OUT(1,4), OUT(1,5), OUT(1,6), OUT(1,7), OUT(1,8) et, OUT(1,9) entre deux échantillons de base TS et LS provenant d'échantillons d'entrée, S(1) et S(2). Dans un second exemple, si R = 2, on calcule 2 échantillons OUT(3,0) et OUT(3,5) entre deux échantillons de base TS et LS provenant d'échantillons d'entrée, S(3) et S(4).

Ainsi, grâce au système décrit, quelle que soit la fréquence des échantillons d'entrée FA, c'est à dire quelle que soit la fréquence symbole Fsy utilisée lors d'une transmission, il est facile de programmer l'oscillateur numérique de commande NCO avec la nouvelle valeur du ratio R pour prendre en compte cette nouvelle fréquence symbole Fsy. Dans ce cas, on recommence les étapes à partir de l'étape d'initialisation START.

Ledit ratio R peut prendre n'importe quelle valeur réelle. Cela permet effectivement une gestion souple desdites fréquences symboles.

Enfin, dans une troisième étape 3), en sortie des moyens d'interpolation INT, les moyens de modulation MOD permettent de moduler le signal ainsi suréchantillonné sur la fréquence porteuse Fca. Par la suite, ledit signal est émis vers le canal CHA.

On notera que, selon une variante de réalisation, le signal échantillonné peut être décalé dans le temps en initialisant, au moyen de l'oscillateur numérique de commande NCO, le paramètre de phase µ à une valeur supérieure ou inférieure à -1. Ceci aura pour avantage d'ajuster une émission du signal numérique DS à transmettre sur le canal par rapport à une fenêtre de temps qui est associée audit modulateur. Ceci est intéressant quand il existe plusieurs sources émettrices. De plus, cela permet un réglage très fin de ladite fenêtre de temps.

Cependant, un dernier problème subsiste. En effet, il est nécessaire de synchroniser l'ensemble des moyens du modulateur numérique DM entre eux en particulier en raison des différentes fréquences utilisées au niveau de chacun desdits moyens. Ainsi, il faut synchroniser les échantillons reçus par les moyens de modulation MOD avec le calcul d'échantillons interpolés, ledit calcul d'échantillons avec l'envoi des échantillons du signal numérique d'entrée S(TA) par les premiers moyens de filtrage FIR et ainsi de suite jusqu'au début de la chaîne dudit modulateur DM. Ce processus de synchronisation est couramment appelé dans la langue anglaise « handshake procedure ». Aussi, bien entendu, le modulateur numérique DM comporte préférentiellement des moyens de synchronisation de signaux appropriés (non représentés) pour effectuer ladite synchronisation. Par exemple, ces moyens sont des files d'attente qui stockent les signaux en attendant que les moyens suivants les lisent, ou encore, ces moyens sont des signaux de contrôle qui informent qu'un signal est disponible ou qu'un signal est lu. Ainsi, chacun des moyens envoie un nouveau signal de sortie dès que le signal de sortie courant est utilisé par les moyens suivants et qu'un signal d'entrée est disponible à partir des moyens précédents.

Ainsi, grâce à l'interpolation, l'invention décrite présente l'avantage de ne plus faire dépendre la fréquence symbole Fsy de la fréquence d'horloge Fclk.
L'invention présente un autre avantage qui est de pouvoir choisir librement sa fréquence symbole Fsy, quelle que soit la fréquence d'horloge utilisée Fclk. Cela permet d'optimiser l'utilisation de la bande passante du canal en particulier lorsqu'il existe plusieurs sources émettrices. En effet, si on a un canal pour lequel on utilise une fréquence porteuse entre 5.5 MHz et 8.5 MHz et des fréquences symboles de 1 MHz environ, et s'il existe quatre sources qui se partagent ce canal, alors chacune utilise le canal dans les intervalles respectifs de [5 MHz, 6 MHz], [6 MHz, 7 MHz], [7 MHz, 8 MHz], et [8 MHz, 9 MHz]. Quand il existe du bruit sur une partie du canal, entre 7.9 MHz et 8.4 MHz, on peut, grâce à l'invention, choisir deux autres fréquences symboles de 0,6 MHz et 0,9 MHz, au facteur de retombée près, de telle manière que le canal soit utilisé dans les intervalles [5 MHz, 6 MHz], [6 MHz, 7 MHz], [7 MHz, 7.9 MHz], et enfin [8,4 MHz, 9 MHz]. Auparavant, on aurait eut une répartition des sources sur le canal de la manière suivante : [5 MHz, 6 MHz], [6 MHz, 7 MHz] uniquement pour deux sources. Une partie du canal entre 7 MHz et 8.4 MHz aurait été inutilisée, bien qu'utilisable. On notera également, que le dispositif selon la présente invention présente l'avantage de ne pas être coûteux et moins complexe par comparaison avec un dispositif qui comporterait plusieurs oscillateurs permettant de gérer différentes fréquences symboles.
Nous allons maintenant expliquer en quoi la fonction G(∂) correspond à une fonction de transfert H(Z) = Z^{-∂/2} exprimant ledit retard ΔT. On a Z = e^{jθ} avec θ = ω*TA une fréquence radiale.
On obtient H(e^{jθ}) = e^{-j∂θ/2} avec une amplitude de 1 et une phase de φ = -∂θ/2.
En terme complexe, on a H(θ) = cos(∂θ/2) - j.sin(-∂θ/2). A ∂ = 0, on prend un échantillon courant comme référence. Afin de calculer un échantillon désiré H(Z), on utilise des moyens de filtrage FIRA qui en créant un retard d'une demi-période TA/2 permettent d'obtenir un premier signal filtré F0, et on calcule ce qu'on doit ajouter (G(Z)) à un échantillon le plus proche (1). On obtient une fonction de différentiation G(Z) ou terme de correction tel que$\text{G(Z) = H(Z) -1}$ soit G(e^{jθ}) = H(e^{jθ}) -1 = e^{-j∂θ/2} - 1 = e^{-j∂θ/4}. (e^{-j}∂^{θ/4} - e^{+j∂θ/4}) = - e^{-j∂θ/4}.2j.sin(∂.θ/4).
Ce qui équivaut à${\text{G(e}}^{\text{jθ}} {\text{) = - j.2sin(∂.θ/4). e}}^{\text{-j∂θ/4}}$ En terme complexe, on obtient G(θ) = cos(∂.θ/2) - 1 - j.sin(∂.θ/2).
L'équation (5) est réécrite de la manière suivante.
G(θ,∂) = ∂.[(θ/2).(sin(∂.θ/4)/(∂.θ/4)).- j.e^{-j∂θ/4}].
Pour ∂ ≅ 1, le terme entre crochet s'écrit F1 = j. 2sin(θ/4).e^{-jθ/4} et
pour ∂ ≅ 0 avec (sin(∂.θ/4)/(∂.θ/4)) ≅ 1, le terme entre crochet s'écrit F2 = -j. θ/2.
Ainsi, la fonction G(θ,∂) peut s'écrire G(θ,∂) = ∂.[k1(∂).F1+k2(∂).F2] + Fe où k1 et k2 sont des facteurs appropriés et Fe est un terme d'approximation. On définit le premier signal filtré F0 pour ∂ = 1 tel que F0 = e^{-jθ/2}. Ainsi, F1 = F0 -1 d'après la relation (4).
On fait une approximation telle que Fe = 0 et k1 et k2 fonctions linéaires de ∂.
On prend k1 = ∂ et k2 = 1- ∂ et on obtient G(∂) = ∂[∂.F1+(1-∂).F2] (6).
Jusqu'à maintenant, on a pris l'échantillon courant comme référence à ∂ = 0. Dans ce cas, lorsque ∂ change de signe, pour calculer des échantillons désirés, il est nécessaire d'ajouter un retard supplémentaire et on doit recalculer le premier signal filtré F0 et par suite F1. La relation 6 n'est donc valable que sur un domaine restreint de ∂, soit 0,...,1 ou -1,..., 0. Pour cette raison, il est plus simple de prendre le premier signal filtré F0 comme échantillon de référence pour calculer les échantillons désirés. Dans ce cas, lorsque ∂ change de signe, ce sont les échantillons non filtrés plutôt que les échantillons filtrés qui doivent être décalés d'une période TA. Ainsi, on n'a pas besoin d'ajouter un retard supplémentaire car les échantillons non filtrés de base LS et TS peuvent être déduits directement de la ligne à retard d'où est issu le signal de référence filtré F0. Seul le délai ∂ doit être modifié en prenant sa valeur complémentaire δ qui correspond au premier paramètre d'interpolation vu précédemment. Les figures 5a et 5b montrent les relations entre les échantillons de base LS et TS, l'échantillon de référence F0 et un échantillon désiré OUT.
Une conséquence est que le signal F1 doit être calculé tel que F1 = échantillon le plus proche - F0 plutôt que F1 = F0 - échantillon le plus proche car on a décalé le signal de référence d'une demi-période TA/2.
On obtient donc la fonction de différentiation G(δ) = |δ|(|δ|.F1 + (1-|δ|).SIGN.F2).

Bien entendu, le cadre de l'invention n'est nullement limité au mode de réalisation décrit et s'étend à d'autres modes de réalisation dans lesquels, par exemple, les deuxièmes moyens de filtrage FIRA des moyens d'interpolation INT ont une structure à trois coefficients multiplicateurs C_{L}1, C_{L}2 et C_{L}3 pour le signal filtré de référence F0, de valeurs respectives 39/64, -9/64 et 2/64.

On notera qu'un tel modulateur numérique peut être utilisé en particulier dans un un boîtier de décodage couramment appelé dans la langue anglaise « set top box » ou dans un câble modem.

Bien entendu, l'invention n'est nullement limitée au domaine de la télévision par câble, elle peut s'étendre à d'autres domaines, notamment à tous ceux qui utilisent un modulateur numérique, tels que le domaine du satellite ou le domaine de la transmission terrestre.

## Revendications

1. Modulateur numérique (DM) comportant une fréquence d'horloge (Fclk) et étant apte à traiter un signal numérique (S(TA)) comprenant des symboles (SYMB) échantillonnés à une fréquence symbole (Fsy), **caractérisé en ce qu'**il comporte :
- des moyens d'interpolation (INT) aptes à interpoler un nouvel échantillon (OUT) à partir de paramètres d'interpolation (δ, SIGN) et de signaux (LS, TS, F0, F2) dérivés du signal numérique (S(TA)), des paramètres d'interpolation (δ, SIGN) étant calculés en fonction d'un ratio (R) variable et réel proportionnel à la fréquence symbole (Fsy) sur la fréquence d'horloge (Fclk).

2. Modulateur numérique selon la revendication 1, **caractérisé en ce que** les moyens d'interpolation (INT) comportent des moyens de filtrage (FIRA) aptes à obtenir, à partir du signal numérique (S(TA)), les signaux dérivés comprenant des signaux de base (LS, TS) et des signaux filtrés (F0, F2), et des moyens de contrôle (CNTRL) aptes à fournir lesdits paramètres d'interpolation (δ, SIGN).

3. Modulateur numérique selon la revendication 1, **caractérisé en ce qu'**il comporte un oscillateur (NCO) apte à initialiser un paramètre de phase (µ), ledit paramètre permettant de calculer lesdits paramètres d'interpolation (δ, SIGN) en fonction dudit ratio (R).

4. Procédé de traitement de signal numérique (S(TA)) comprenant des symboles (SYMB) échantillonnés à une fréquence symbole (Fsy), **caractérisé en ce qu'**il comporte les étapes de :
- calculer des paramètres d'interpolation (δ, SIGN),
- calculer un nouvel échantillon (OUT) à partir des paramètres d'interpolation (δ, SIGN) et de signaux (LS, TS, F0, F2) dérivés du signal numérique (S(TA)), des paramètres d'interpolation (δ, SIGN) étant calculés en fonction d'un ratio (R) variable et réel proportionnel à la fréquence symbole (Fsy) sur la fréquence d'horloge (Fclk).

5. Procédé de traitement de signal selon la revendication 4, **caractérisé en ce que** l'étape de retarder le signal comporte une sous-étape supplémentaire de :
- filtrer le signal numérique (S(TA)) pour obtenir les signaux dérivés comprenant des signaux de base (LS, TS) et des signaux filtrés (F0, F2).

6. Procédé de traitement de signal selon la revendication 4, **caractérisé en ce qu'**il comporte une étape supplémentaire d'initialiser un paramètre de phase (µ), ledit paramètre permettant de calculer lesdits paramètres d'interpolation (δ, SIGN) en fonction dudit ratio (R).

7. Boîtier de décodage comprenant un modulateur numérique tel que revendiqué dans l'une des revendications 1 à 3.

8. Modem câble comprenant un modulateur numérique tel que revendiqué dans l'une des revendications 1 à 3.
